# EUROPEAN PATENT APPLICATION

(11) **EP 4 644 019 A1**
(43) Date of publication of application: **05.11.2025**
(21) Application number: 25158850.5
(22) Date of filing: 19.02.2025
(51) Int. Cl.: B22F 10/28, B22F 10/36, B22F 10/50, B22F 10/80, B22F 12/41, B22F 12/43, B22F 12/45, B22F 12/90, B33Y 50/00, B33Y 10/00, B33Y 40/00, B33Y 50/02, B33Y 30/00

(54) **HYBRID POWDER BED FUSION PRINTING METHOD WITH LASER FORGING, DEVICE AND STORAGE MEDIUM**

(30) Priority: 18.04.2024 CN 202410465813
(71) Applicant: Xi'an Aerospace Mechatronics & Intelligent Manufacturing Co., Ltd, Xi'an, Shaanxi 710000 (CN)
(72) Inventor: Liu, Suoli, Xi'an, Shaanxi, 710000 (CN); Cao, Tong, Xi'an, Shaanxi, 710000 (CN); Zhang, Ting, Xi'an, Shaanxi, 710000 (CN); Wang, Weimin, Xi'an, Shaanxi, 710000 (CN); Li, Qing, Xi'an, Shaanxi, 710000 (CN); Hu, Jiawei, Xi'an, Shaanxi, 710000 (CN)
(74) Representative: Petraz, Gilberto Luigi

(57) **Abstract**

The invention provide a de-supporting forging printing method, a de-supporting forging printing system, a de-supporting forging printing device, and a medium. The method includes: obtaining a stress field concentration area by simulating a stress field for a geometric model of a workpiece to be printed during a forging printing process through a numerical simulation method; obtaining stress distribution data by performing different numbers of forging printing simulations on the stress field concentration area with ultrafast laser under a de-supporting condition based on the numerical simulation method; selecting target stress distribution data from the stress distribution data according to a preset stress range, and determining a powder bed laser configuration parameter and an ultrafast laser configuration parameter according to the target stress distribution data; and controlling powder bed laser and ultrafast laser to perform forging printing on the workpiece to be printed according to corresponding laser parameters and scanning paths.

## Description

### TECHNICAL FIELD

The present invention relates to the technical field of additive manufacturing, and in particular to a de-supporting forging printing method, a de-supporting forging printing system, a de-supporting forging printing device, and a medium.

### BACKGROUND

With the development of science and technology, laser powder bed fusion technology is commonly used to process complex special-shaped workpieces in the related art. In the manufacturing process, in order to prevent residual tensile stress caused by high temperature from causing deformation and cracking of components, a large number of supports are usually used to avoid defects in components. However, the existence of supports may increase manufacturing time and cost, and the subsequent removal of the supports may affect the geometric degree of freedom of the workpieces. The de-supporting printing methods in the relate art all compromise the requirements of the components for printing size and pursue printing quality, without fundamentally regulating the stress field, which may limit the types of printable components of laser powder bed melting technology, thus, it is difficult to effectively perform de-supporting forging printing on the complex workpieces in the related art.

### SUMMARY

Embodiments of the present invention provide a de-supporting forging printing method, a de-supporting forging printing system, a de-supporting forging printing device, and a medium, to solve the problem of difficult to effectively perform de-supporting forging printing on the complex workpieces in the related art.

According to a first aspect of embodiments of the present invention, a de-supporting forging printing method is provided. The method includes: obtaining a stress field concentration area by simulating a stress field for a geometric model of a workpiece to be printed during a forging printing process through a numerical simulation method; obtaining stress distribution data by performing different numbers of forging printing simulations on the stress field concentration area with ultrafast laser under a de-supporting condition based on the numerical simulation method; selecting target stress distribution data from the stress distribution data according to a preset stress range, and determining a powder bed laser configuration parameter and an ultrafast laser configuration parameter according to the target stress distribution data, in which the powder bed laser configuration parameter includes a powder bed laser parameter and a powder bed scanning path, and the ultrafast laser configuration parameter includes an ultrafast laser parameter and an ultrafast laser scanning path; and controlling powder bed laser and ultrafast laser to perform forging printing on the workpiece to be printed according to corresponding laser parameters and scanning paths.

According to a second aspect of embodiments of the present invention, a de-supporting forging printing system is provided. The system includes: a powder spreading device, a powder bed laser device, an image monitoring device, an ultrafast laser device, and a central controller. The powder spreading device is configured to spread metal powder evenly onto a molding substrate. The powder bed laser device is configured to emit powder bed laser according to a powder bed laser parameter, and control the powder bed laser to fuse the metal powder according to a powder bed scanning path. The image monitoring device is configured to obtain a working signal of the powder bed laser device by monitoring the powder bed laser device, and transmit the working signal to the central controller. The ultrafast laser device is configured to emit ultrafast laser according to an ultrafast laser parameter after receiving an emission signal, and control the ultrafast laser to perform forging printing on a stress field concentration area in a fused metal powder according to an ultrafast laser scanning path and a number of forging printings. The central controller is configured to determine a powder bed configuration parameter, an ultrafast laser configuration parameter, and a number of forging printings of the ultrafast laser by receiving an imported slice file, receive the working signal and generate the emission signal, and stop printing work by receiving a stop signal sent by the image monitoring device, in which the powder bed configuration parameter includes the powder bed laser parameter and the powder bed scanning path, and the ultrafast laser parameter includes the ultrafast laser parameter and the ultrafast laser scanning path.

According to a third aspect of embodiments of the present invention, a de-supporting forging printing device is provided. The device includes: a stress field simulating unit, configured to obtain a stress field concentration area by simulating a stress field of a geometric model for a workpiece to be printed during a forging printing process through a numerical simulation method; a forging printing unit, configured to obtain stress distribution data by performing different numbers of forging printing simulations on the stress field concentration area with ultrafast laser under a de-supporting condition based on the numerical simulation method; a selecting unit, configured to select target stress distribution data from the stress distribution data according to a preset stress range, and determine a powder bed laser configuration parameter and an ultrafast laser configuration parameter according to the target stress distribution data, in which the powder bed laser configuration parameter includes a powder bed laser parameter and a powder bed scanning path, and the ultrafast laser configuration parameter includes an ultrafast laser parameter and an ultrafast laser scanning path; and a printing unit, configured to control powder bed laser and ultrafast laser to perform forging printing on the workpiece to be printed according to corresponding laser parameters and scanning paths.

According to a fourth aspect of embodiments of the present invention, a computer device is provided. The computer device includes: a processor; and a memory having a computer program stored thereon. When the processor executes the computer program, the above method is performed.

According to a fifth aspect of embodiments of the present invention, a computer-readable storage medium is provided. The storage medium stores a computer program, and the computer program includes program instructions. When the program instructions are executed by the processor, the above method is performed.

Embodiments of the present invention provide a de-supporting forging printing method, a de-supporting forging printing system, a de-supporting forging printing device, and a medium. The method includes: obtaining a stress field concentration area by simulating a stress field for a geometric model of a workpiece to be printed during a forging printing process through a numerical simulation method; obtaining stress distribution data by performing different numbers of forging printing simulations on the stress field concentration area with ultrafast laser under a de-supporting condition based on the numerical simulation method; selecting target stress distribution data from the stress distribution data according to a preset stress range, and determining a powder bed laser configuration parameter and an ultrafast laser configuration parameter according to the target stress distribution data, in which the powder bed laser configuration parameter includes a powder bed laser parameter and a powder bed scanning path, and the ultrafast laser configuration parameter includes an ultrafast laser parameter and an ultrafast laser scanning path; and controlling powder bed laser and ultrafast laser to perform forging printing on the workpiece to be printed according to corresponding laser parameters and scanning paths. The embodiments of the present invention determine the stress field concentration area through simulation printing to determine the number of forging printings and configuration parameters of the ultrafast laser, so that, in the laser powder bed printing process, the ultrafast laser is used to irradiate the molten layer, and impact and forge the stress field concentration area in the fusion layer, layer by layer, to reduce the stress level, reduce the number of supports required for printing components, and achieve additive manufacturing of de-supporting forging printing with complex structures.

### BRIEF DESCRIPTION OF THE DRAWINGS

In order to more clearly illustrate the technical solution of the embodiments of the present invention, a brief introduction will be given to the accompanying drawings in the description of the embodiments. It is obvious that the accompanying drawings described below are some embodiments of the present invention. For those skilled in the art, other drawings can be obtained based on these accompanying drawings without creative labor.
FIG. 1 is a flowchart of a de-supporting forging printing method according to an embodiment of the invention.
FIG. 2 is a flowchart of a de-supporting forging printing method according to an embodiment of the invention.
FIG. 3 is a flowchart of a de-supporting forging printing method according to an embodiment of the invention.
FIG. 4 is a flowchart of a de-supporting forging printing method according to an embodiment of the invention.
FIG. 5 is a flowchart of a de-supporting forging printing method according to an embodiment of the invention.
FIG. 6 is a block diagram of a de-supporting forging printing system according to an embodiment of the invention.
FIG. 7 is a block diagram of a de-supporting forging printing device according to an embodiment of the invention.
FIG. 8 is a schematic diagram of a computer device according to an embodiment of the invention.

### DETAILED DESCRIPTION

Technical solutions in embodiments of the present invention will be clearly and completely described with reference to the accompanying drawings. Obviously, the described embodiments are a part of the embodiments of the present invention, but not all of them. Based on the embodiments of the present invention, all other embodiments obtained by those skilled in the art without creative labor are within the scope of protection of the present invention.

It should be understood that, when used in the description and the appended claims, the terms "including" and "containing" indicate the presence of the described features, entirety, steps, operations, elements, and/or components, but do not exclude the presence or addition of one or more other features, entirety, steps, operations, elements, components, and/or sets thereof.

It should also be understood that, the terms used in the description are only for the purpose of describing specific embodiments and are not intended to limit the invention. As used in the present description and appended claims, unless the context clearly indicates otherwise, the singular forms "a", "an", and "the" are intended to include the plural form.

It should be further understood that the term "and/or" used in the description and the appended claims of the present invention refers to any or all combinations of one or more of the listed items, and include these combinations.

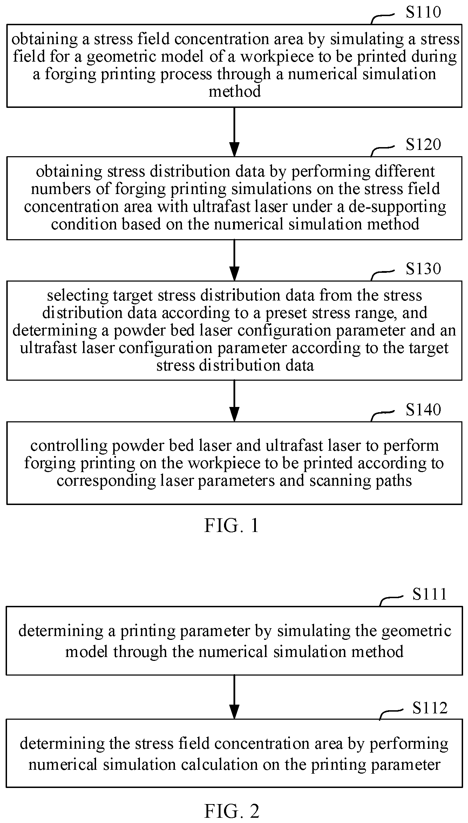

As shown in FIG. 1, FIG. 1 is a flowchart of a de-supporting forging printing method provided by an embodiment of the present invention. The de-supporting forging printing method in the embodiment can be applied to the printing of a complex workpiece, to remove supports of the complex workpiece. The powder is fused by powder bed laser. Ultrafast laser forging printing is performed on the stress field concentration area obtained after the fusion, to reduce the stress level, reduce the number of supports required for printing the workpiece, and achieve additive manufacturing of de-supporting forging printing for a complex structure.

FIG. 1 is a flowchart of a de-supporting forging printing method provided in an embodiment of the present invention. As shown in FIG. 1, the method includes the following steps S110-S140.

At S110, a stress field concentration area is obtained by simulating a stress field of a geometric model for a workpiece to be printed during a forging printing process through a numerical simulation method.

In this embodiment, the workpiece to be printed is a workpiece with a complex shape that requires forging printing. The geometric model is a model constructed based on the shape and size of the workpiece to be printed. The geometric model can be constructed through data modeling or a modeling platform, which is not limited in the invention. The stress refers to an internal stress generated by interaction between different parts of an object when it undergoes deformation due to external factors such as a change of force, humidity, or temperature, etc. Each point in any object or rock mass has a corresponding momentary stress state. The stress field refers to a spatial stress field composed of momentary stress states corresponding to a series of points in any object or rock mass. The stress field concentration area refers to an area that is prone to defects and that requires ultrafast laser forging printing. For example, both an area with an excessively high tensile stress, and an area that is prone to deformation or cracking are stress field concentration areas. A tensile stress refers to a reaction force of an object to an external force that cause the object to have a stretching tendency. The numerical simulation method can comprehensively simulate a complex printing process of a workpiece, and can consider factors such as uncertainty and interaction of multiple parameters, such as a finite element method or a finite difference method, which is not limited herein. The stress field of the geometric model during the forging printing process can be simulated using the numerical simulation method. For example, a printing geometric model can be imported into a simulation system with a numerical simulation method. Finite element simulation software and other software are simulation systems with numerical simulation methods. By selecting a corresponding printing material and other numerical values, the finite element simulation software can perform simulation calculation to obtain the stress field concentration area. The stress field of the geometric model for the workpiece to be printed during the forging printing process is simulated by the numerical simulation method, and an area on which ultrafast laser forging printing needs to be performed can be determined, which facilitates the determination of a configuration parameter of ultrafast laser.

In an embodiment, as shown in FIG. 2, step S110 further includes steps S111-S112.

At S111, a printing parameter is determined by simulating the geometric model through the numerical simulation method.

At S112, the stress field concentration area is determined by performing numerical simulation calculation on the printing parameter.

In this embodiment, the printing parameter is a parameter that need to be set when printing the workpiece to be printed, such as laser power, scaning speed, spot diameter, and other parameters. The geometric model can be simulated using the numerical simulation method to determine the printing parameter. Specifically, the geometric model can be imported into a software system constructed based on the numerical simulation method, such as ABAQUS, ANSYS and other finite element simulation software, which is not limited herein. The finite element simulation software can simulate the parameter during the printing process according to the numerical simulation method to determine the printing parameter, or the printing parameter can be customized. The finite element simulation software performs mesh division and forging printing simulation calculation according to the determined printing parameter, and the stress field concentration area can be determined. By determining the stress field concentration area, the area on which the ultrafast laser forging printing is to be performed after removing the supports during the forging printing process is acknowledged.

At S120, stress distribution data is obtained by performing different numbers of forging printing simulations on the stress field concentration area with ultrafast laser forging printing under a de-supporting condition based on the numerical simulation method.

In this embodiment, the ultrafast laser is an ultra-short pulse laser with a pulse width on a time scale of 10⁻¹²-10⁻¹⁵, with an extremely high momentary power density, which reaches the level of TW/cm2. When the ultrafast laser is irradiated on the surface of metal materials, ultra-high pressure shock waves can be induced without the need for a confinement layer, and the mechanical effects of the shock waves cause severe plastic deformation of the material surface (in a depth range of hundreds of micrometers). The stress distribution data refers to stress data and stress distribution in the stress field concentration area. Simulation is performed on the stress field concentration area using the finite element simulation software constructed based on the numerical simulation method. The simulation involves performing different numbers of forging printings on the stress field concentration area using the ultrafast laser in a case of removing the supports. For example, the ultrafast laser is controlled to perform one impact forging printing, two impact forging printings, and three impact forging printings sequentially on the stress field concentration area. The finite element simulation software further performs stress field simulation according to the stress fields of the stress field concentration area after performing the different numbers of forging printings, to obtain corresponding stress distribution data. By performing the different numbers of forging printing simulations with ultrafast laser under the de-supporting condition, corresponding stress distribution data is obtained to determine the stress distribution data under different numbers of forging printings, so as to select a suitable number of forging printings and a suitable configuration parameter.

S130, target stress distribution data is selected from the stress distribution data according to a preset stress range, and a powder bed laser configuration parameter and an ultrafast laser configuration parameter are determined based on the target stress distribution data. The powder bed laser configuration parameter includes a powder bed laser parameter and a powder bed scanning path, and the ultrafast laser configuration parameter includes an ultrafast laser parameter and an ultrafast laser scanning path.

In this embodiment, the target stress distribution data is the most effective stress data. The target stress distribution data is selected from the stress distribution data based on the preset stress range. Specifically, it is determined whether each of multiple sets of stress distribution data generated by simulation forging printing are within the preset stress range. The stress distribution data with the most obvious stress improvement effect among the stress distribution data within the preset stress range is determined as the target stress distribution data. The preset stress range is a range determined based on the stress situation of the workpiece to be printed, which is not limited herein, as long as that no defect is generated during the forging printing process of the workpiece to be printed. Based on the target stress distribution data, the number of forging printings and the corresponding laser configuration parameters in the forging printing process to which the target stress distribution data belongs. The powder bed laser configuration parameter includes the powder bed laser parameter and the powder bed scanning path, and the ultrafast laser configuration parameter includes the ultrafast laser parameter and the ultrafast laser scanning path. Specifically, the powder bed laser configuration parameter and the ultrafast laser configuration parameter can be generated by path planning software. By selecting the target stress distribution data, the powder bed laser configuration parameter and the ultrafast laser configuration parameter are determined for effective forging printing of the workpiece to be printed under the de-supporting condition.

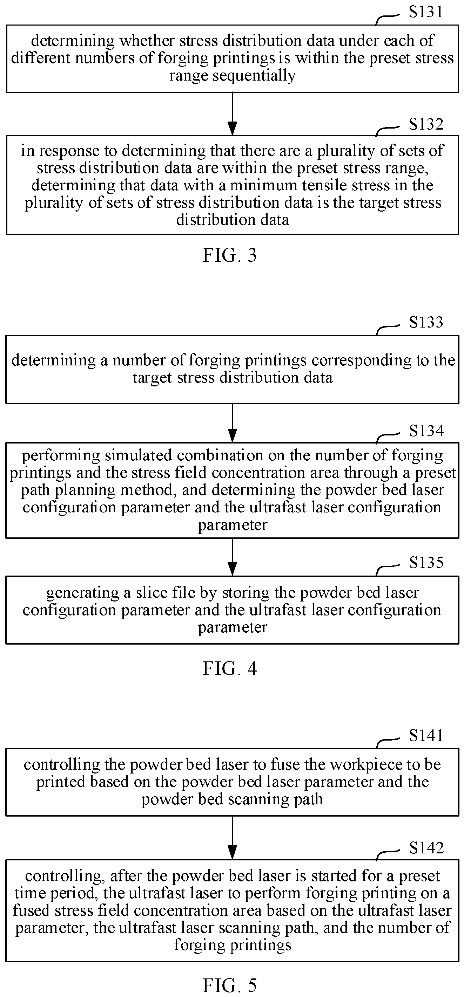

In an embodiment, as shown in FIG. 3, step S13 further includes steps S131-S132.

At S131, it is determined whether stress distribution data under each of different numbers of forging printings is within the preset stress range;

At S 132, if it is determined that there are a plurality of multiple sets of stress distribution data are within the preset stress range, it is determined that the data with a minimum tensile stress in the plurality of sets of stress distribution data is the target stress distribution data.

In this embodiment, the preset stress range is determined based on the information of the workpiece to be printed. For example, a stress range of an engine front cover is 130 MPa -230 MPa. It is determined whether the stress distribution data generated by each of the different numbers of forging printings are within the preset stress range sequentially. If there is only one set of stress distribution data within the preset stress range, the one set of stress distribution data is the target stress distribution data. If none of them are within the preset stress range, the number of forging printings and the parameters in the printing process are adjusted, and the forging printing simulation is repeated until the stress distribution data is within the preset stress range. If there are multiple sets of stress distribution data that are all within the preset stress range, the data with a minimum tensile stress in the stress distribution data is the target stress distribution data is the target stress distribution data. By determining whether the stress distribution data under each of different numbers of forging printings are within the preset stress range, the powder bed laser configuration parameter and the ultrafast laser configuration parameter are determined based on the selected target stress distribution data, so as to effectively perform forging printing on the workpiece under the de-supporting condition.

In an embodiment, as shown in FIG. 4, step S130 further includes steps S133-S135.

At S133, a number of forging printings corresponding to the target stress distribution data is determined based on the target stress distribution data.

At S134, simulated combination is performed on the number of forging printings and the stress field concentration area through a preset path planning method, and the powder bed laser configuration parameter and the ultrafast laser configuration parameter are determined.

At S135, a slice file is generated by storing the powder bed laser configuration parameter and the ultrafast laser configuration parameter.

In this embodiment, the number of forging printings is a number of times of the simulated ultrafast laser forging printing in the target stress distribution data. The powder bed laser configuration parameter includes a parameter of the powder bed laser and a scanning path of the powder bed laser. The ultrafast laser configuration parameter includes a parameter of the ultrafast laser and a scanning path of the ultrafast laser in the stress concentration area. The slice refers to convert a model file containing configuration parameters into action data of a 3D printer through software (Cura, Simplify3D, Slic3R, etc.), i.e., dividing an entity into multiple layers of equal thickness. According to the target stress distribution data, the corresponding number of forging printings can be determined, and the number of forging printings can be simulated and combined with the stress field concentration area through path planning software to determine the powder bed laser configuration parameter and the ultrafast laser configuration parameter. The path planning software includes but is not limited to LMDCAM, LiMAMS SLM and other software. The path planning software can optimize and determine the appropriate laser scanning path according to the needs. The powder bed laser configuration parameter and the ultrafast laser configuration parameter are stored to generate the slicing file, so that the de-supporting forging printing system can print the workpiece to be printed based on the configuration parameters and other information in the slicing file. By simulating and combining the number of forging printings with the stress field concentration area, the powder bed laser configuration parameter and the ultrafast laser configuration parameter are determined, so as to obtain an effective de-supporting forging printing path and required parameters.

At S140, powder bed laser and ultrafast laser are controlled perform forging printing on the workpiece to be printed according to their corresponding laser parameters and scanning paths.

In this embodiment, the powder bed laser and the ultrafast laser are controlled to perform forging printing on the workpiece to be printed. Specifically, the powder bed laser is emitted according to the powder bed laser parameter pair, the powder bed laser passing through a device such as a galvanometer for laser refraction, and the metal powder of the workpiece to be printed is fused according to the powder bed scanning path. After a period of time, the ultrafast laser is emitted according to the ultrafast laser path, so that the ultrafast laser can perform forging printing on the stress concentration area in the melted metal powder according to the ultrafast laser path, so that the ultrafast laser and the powder bed laser can scan the same area as much as possible at the same time, completing the impact forging strengthening of the current layer. By using the ultrafast laser to irradiate the fusion layer, the stress field concentration area in the molten layer is impacted and forged layer by layer to reduce the stress level, decrease the number of supports required for printing components, and achieve additive manufacturing of de-supporting forging printing with complex structures.

In an embodiment, as shown in FIG. 5, step 1404 further includes steps S141-S142.

At S141, the powder bed laser is controlled to fuse the workpiece to be printed based on the powder bed laser parameter and the powder bed scanning path.

At S142, the ultrafast laser is controlled to perform forging printing on the stress field concentration area after melting based on the ultrafast laser parameter, the ultrafast laser scanning path, and the number of forging printings after the powder bed laser is started for a preset time period.

In this embodiment, the powder bed laser starts to fuse the metal powder based on the powder bed laser scanning path and the powder bed laser parameter in the generated slice file, followed by rapid solidification to form a metallurgical bonding layer. After the powder bed laser starts for the preset time period, it emits the ultrafast laser according to the ultrafast laser parameter in the slicing file, and causes the ultrafast laser to impact and forge the stress field concentration area in the molten layer according to the ultrafast laser path, to complete the impact forging strengthening of the current layer. The preset time period can be adjusted according to the scanning paths of the powder bed laser and the ultrafast laser, so that the ultrafast laser and the powder bed laser can scan the same area as much as possible at the same time, which is not limited herein. After the powder bed laser melts all areas of the current layer according to the scanning path of the powder bed laser, stroke is performed. After the stroke is completed, it waits for the current molten layer to be strengthened by impact forging, and then the powder bed laser and the ultrafast laser enter a waiting state, to wait for a new round of powder spreading. After the powder spreading is completed, the powder bed laser and the ultrafast laser continue to work according to their corresponding configuration parameters until all layers are scanned and the forging printing is completed. By using the powder bed laser and the ultrafast laser for forging printing, low-stress additive manufacturing of metal components can be efficiently and quickly achieved without any support, saving costs and time and increasing manufacturing flexibility.

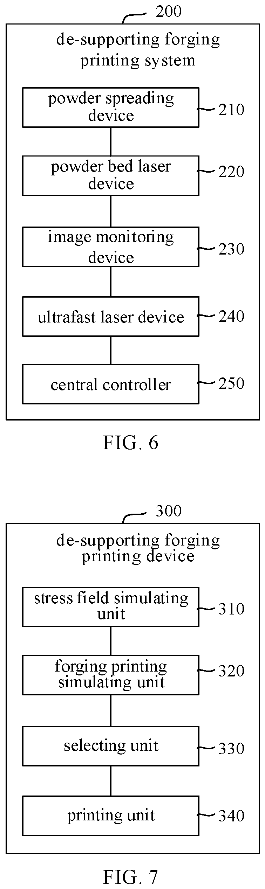

Embodiments of the invention also provide a de-supporting forging printing system, as shown in FIG. 6. The de-supporting forging printing system includes: a powder spreading device 210, a powder bed laser device 220, an image monitoring device 230, an ultrafast laser device 240, and a central controller 250. The powder spreading device 210 is configured to spread metal powder evenly onto a molding substrate. The powder bed laser device 220 is configured to emit powder bed laser according to a powder bed laser parameter, and control the powder bed laser to fuse the metal powder according to a powder bed scanning path. The image monitoring device 230 is configured to obtain a working signal of the powder bed laser device by monitoring the powder bed laser device, and transmit the working signal to the central controller. The ultrafast laser device 240 is configured to emit ultrafast laser according to an ultrafast laser parameter after receiving an emission signal, and control the ultrafast laser to perform forging printing on a stress field concentration area in a fused metal powder according to an ultrafast laser scanning path and a number of forging printings. The central controller 250 is configured to determine a powder bed configuration parameter, an ultrafast laser configuration parameter, and a number of forging printings of the ultrafast laser by receiving an imported slice file, receive the working signal and generate the emission signal, and stop printing work by receiving a stop signal sent by the image monitoring device, in which the powder bed configuration parameter includes the powder bed laser parameter and the powder bed scanning path, and the ultrafast laser parameter includes the ultrafast laser parameter and the ultrafast laser scanning path.

In this embodiment, the powder spreading device is configured to spread metal powder evenly onto a molding substrate. The powder spreading device includes a powder cylinder and a scraper, etc. The metal powder is taken out from the powder cylinder and spread flat onto the molding substrate through the scraper, and the powder outside the molding substrate is recycled. By spreading the metal powder onto the molding substrate to complete the printing work, the laser can effectively process the metal powder.

In this embodiment, the powder bed laser device is configured to emit powder bed laser according to a powder bed laser parameter, and control the powder bed laser to fuse the metal powder according to a powder bed scanning path. The powder bed laser device is a device used for emitting the powder bed laser. In this embodiment, the powder bed laser device is a continuous wave fiber laser with a laser power of 500-1000W and a focused spot diameter of 70-120 µ m, which can provide a heat source for powder fusion. After the scraper of the powder spreading device completes the powder spreading, the powder bed laser device emits the powder bed laser according to the powder bed laser parameter, and controls the powder bed laser to fuse the metal powder according to the powder bed laser scanning path. The powder bed laser passes through a powder bed galvanometer system and converges into the molding substrate. The metal powder is fused by the powder bed laser, to perform initial processing on the metal powder.

In this embodiment, the image monitoring device is configured to obtain a working signal of the powder bed laser device by monitoring the powder bed laser device, and transmit the working signal to the central controller. The image monitoring device is a device that monitors a movement trajectory of a powder bed laser focus and provides signals. The image monitoring device consists of a CCD camera and an infrared thermal imager. The camera monitors the movement trajectory of the powder bed laser, and when it is monitored that the powder bed laser starts fusion, a working signal of the powder bed laser is generated. The working signal is sent to the central controller, so that the central controller may send an emission signal to the ultrafast laser device after a preset time interval. By obtaining the working signal of the powder bed laser, the central controller can generate the emission signal within a reasonable time period to perform the next step of laser processing on the metal powder.

In an embodiment, the image monitoring device is used to determine whether a scanning path error or a powder spreading defect occurs during a fusing or forging process. If a scanning path error or a powder spreading defect occurs, the printing is stopped by generating a defect signal. The image monitoring device can obtain a powder spreading status and a laser scanning path in real time during the forging printing process, and it can be determined whether there is a scanning path error or a powder spreading defect during the printing process based on a set defect condition, such as splashing of molten pool, unfused, and other defects. If it is determined that one of the defects is occurred, the defect signal is generated to stop the printing. The defect signal is sent to the central controller to re-spread powder and reprint the defective part. The image monitoring device can identify and determine whether there is a defect during the metal powder processing, to ensure the printing quality of complex workpieces.

In this embodiment, the ultrafast laser device is configured to emit ultrafast laser according to an ultrafast laser parameter after receiving an emission signal, and control the ultrafast laser to perform forging printing on a stress field concentration area in a fused metal powder according to an ultrafast laser scanning path and a number of forging printings. The ultrafast laser device is a device used for transmitting the ultrafast laser. After receiving the emission signal sent by the central controller, the ultrafast laser device emits the ultrafast laser to perform impact forging on the stress field concentration area in the fusion layer according to the ultrafast laser path, to complete the impact forging strengthening of the current layer. By emitting the ultrafast laser for performing the forging printing on the metal powder, low-stress additive manufacturing for metal components can be efficiently and quickly achieved.

In this embodiment, the central controller is configured to determine a powder bed configuration parameter, an ultrafast laser configuration parameter, and a number of forging printings of the ultrafast laser by receiving an imported slice file, receive the working signal and generate the emission signal, and stop printing work by receiving a stop signal sent by the image monitoring device. The powder bed configuration parameter includes the powder bed laser parameter and the powder bed scanning path, and the ultrafast laser parameter includes the ultrafast laser parameter and the ultrafast laser scanning path. The central controller receives the imported slice file, and determine the powder bed configuration parameter, the ultrafast laser configuration parameter, and the number of forging printings of the ultrafast laser, and synchronizes the configuration parameters to the powder bed laser device and the ultrafast laser device to determine the forging and printing times of the ultrafast laser respectively, so that they can emit laser according to the corresponding parameters, and stop the forging printing by receiving the stop signal. The laser emission of the laser emitting device and stopping the forging printing are controlled by the central controller.

FIG. 7 is a block diagram of a de-supporting forging printing device 300 provided in an embodiment of the present invention. As shown in FIG. 7, corresponding to the above de-supporting forging printing method, the present invention also provides a de-supporting forging printing device. The de-supporting forging printing device includes units for executing the de-supporting forging printing method as described above, and the device can be configured in terminals such as desktop computers, tablets, laptops, etc. Specifically, referring to FIG. 7, the de-supporting forging printing device includes a stress field simulation unit 310, a forging printing simulating unit 320, a selecting unit 330, and a printing unit 340.

The stress field simulating unit 310 is configured to obtain a stress field concentration area by simulating a stress field of a geometric model for a workpiece to be printed during a forging printing process through a numerical simulation method.

In an embodiment, the stress field simulating unit 310 includes a simulating and determining unit and a calculation unit.

The simulating and determining unit is configured to determine a printing parameter by simulating the geometric model through the numerical simulation method.

The calculation unit configured to determine the stress field concentration area by performing numerical simulation calculation on the printing parameter.

The forging printing simulating unit 320 is configured to obtain stress distribution data by performing different numbers of forging printing simulations on the stress field concentration area with ultrafast laser under a de-supporting condition based on the numerical simulation method.

The selecting unit 330 is configured to select target stress distribution data from the stress distribution data according to a preset stress range, and determine a powder bed laser configuration parameter and an ultrafast laser configuration parameter according to the target stress distribution data, in which the powder bed laser configuration parameter includes a powder bed laser parameter and a powder bed scanning path, and the ultrafast laser configuration parameter includes an ultrafast laser parameter and an ultrafast laser scanning path.

In an embodiment, the selecting unit 330 includes a judging unit and an electing unit.

The judging unit is configured to determine whether stress distribution data under each of different numbers of forging printings is within the preset stress range sequentially.

The electing unit is configured to, in response to determining that there are a plurality of sets of stress distribution data are within the preset stress range, determine that data with a minimum tensile stress in the plurality of sets of stress distribution data is the target stress distribution data.

In an embodiment, the selecting unit 330 includes a first determining unit, a second determining unit, and a storing unit.

The first determining unit is configured to determine a number of forging printings corresponding to the target stress distribution data.

The second determining unit is configured to perform simulated combination on the number of forging printings and the stress field concentration area through a preset path planning method, and determine the powder bed laser configuration parameter and the ultrafast laser configuration parameter.

The storing unit is configured to generate a slice file by storing the powder bed laser configuration parameter and the ultrafast laser configuration parameter.

The printing unit 340 is configured to control powder bed laser and ultrafast laser to perform forging printing on the workpiece to be printed according to corresponding laser parameters and scanning paths.

In an embodiment, the printing unit 340 includes a fusion unit and a forging printing unit.

The fusion unit is configured to control the powder bed laser to fuse the workpiece to be printed based on the powder bed laser parameter and the powder bed scanning path; and

The forging printing unit is configured to control, after the powder bed laser is started for a preset time period, the ultrafast laser to perform forging printing on a fused stress field concentration area based on the ultrafast laser parameter, the ultrafast laser scanning path, and the number of forging printings.

It should be noted that, those skilled in the art can clearly understand that the specific implementation process of the forging de-supporting forging printing device 300 and the respective units can refer to the corresponding descriptions in the forging method embodiments. For the convenience and conciseness of the description, it will not be repeated here.

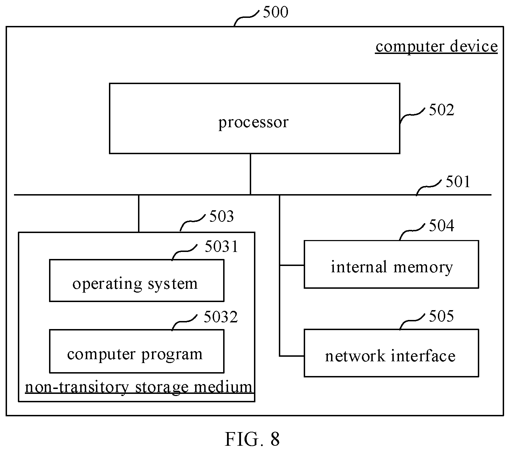

The above-mentioned de-supporting forging printing device can be implemented in a form of a computer program, which can run on a computer device as shown in FIG. 8.

As shown in FIG. 8, FIG. 8 is a block diagram of a computer device according to an embodiment of the present invention. The computer device 500 may be a terminal or a server. The terminal can be an electronic device with communication functions, such as a smartphone, a tablet, a laptop, a desktop computer, a personal digital assistant, and a wearable device. The server can be an independent server or a server cluster composed of multiple servers.

As shown in FIG. 8, the computer device 500 includes a processor 502, a memory, and a network interface 505 connected through a system bus 501. The memory may include a non-transitory storage medium 503 and an internal memory 504.

The non-transitory storage medium 503 can store an operating system 5031 and a computer program 5032. The computer program 5032 includes program instructions. When the program instructions are executed, the processor 502 is caused to perform a de-supporting forging printing method.

The processor 502 is used to provide computing and control capabilities to support the operation of the entire computer device 500.

The internal memory 504 provides an environment for the execution of the computer program 5032 in the non-transitory storage medium 503. When the computer program 5032 is executed by the processor 502, it can cause the processor 502 to perform a de-supporting forging printing method.

This network interface 505 is used for network communication with other devices. Those skilled in the art can understand that the structure shown in FIG. 8 is only a block diagram of a part of the structure related to the present invention, and does not constitute a limitation on the computer device 500 on which the solutions of the present invention is applied to. The computer device 500 may include more or fewer components than shown in the FIG. 8, or certain components may be combined, or different component arrangements may be used.

The processor 502 is used to run the computer program 5032 stored in the memory to perform the steps of the above method.

It should be understood that, in the embodiments of the present invention, the processor 502 may be a Central Processing Unit (CPU), and the processor 502 may also be other general-purpose processors, Digital Signal Processor (DSP), Application Specific Integrated Circuit (ASIC), Field Programmable Gate Array (FPGA) or other programmable logic devices, discrete gates or transistor logic devices, discrete hardware components, etc. The general-purpose processor can be a microprocessor or any conventional processor.

Those skilled in the art can understand that all or part of the processes implementing the above embodiments can be completed by a computer program instructing relevant hardware. The computer program includes program instructions, which can be stored in a storage medium that is a computer-readable storage medium. The program instructions are executed by at least one processor in the computer system, to perform the flow steps in the above method embodiments.

Therefore, the present invention also provides a storage medium. The storage medium can be a computer-readable storage medium. The storage medium stores a computer program. The computer program includes program instructions. When executed by the processor, the program instructions cause the processor to perform the steps of the method described above.

The storage medium can be various computer-readable storage media that can store program codes, such as USB flash drives, portable hard drives, Read Only Memory (ROM), magnetic disks, or optical disks.

Those skilled in the art can realize that the units and algorithm steps in the examples described in the embodiments disclosed in this invention can be realized in electronic hardware, computer software, or a combination of both. In order to clearly illustrate the interchangeability of hardware and software, the composition and steps of the respective examples have been generally described in the above description according to their functions. Whether these functions are executed in hardware or software depends on the specific application and design constraints of the technical solution. Those skilled in the art can use different methods to achieve the described functions for each specific application, but such implementations should not be considered beyond the scope of the present invention.

In the several embodiments provided by the present invention, it should be understood that the disclosed devices and methods can be implemented in other ways. For example, the device embodiments described above are merely illustrative. For example, the division of the respective units is only a logical functional division, and there may be other division methods in actual implementation. For example, multiple units or components can be combined or integrated into another system, or some features can be ignored or not executed.

The steps in the method according to the embodiments of the present invention can be sequentially adjusted, merged, and deleted according to actual needs. The units in the device according to embodiments of the present invention can be merged, divided, and deleted according to actual needs. In addition, the various function units in various embodiments of the present invention can be integrated into one processing unit, or they can exist separately physically, or two or more units can be integrated into one unit.

If the integrated unit is implemented in the form of a software function unit and sold or used as an independent product, it can be stored in a storage medium. Based on this understanding, the technical solution of the present invention essentially or partially contributes to the related art, or all or part of the technical solution can be embodied in the form of a software product, which is stored in a storage medium and includes several instructions to cause a computer device (which can be a personal computer, a terminal, or a network device, etc.) to perform all or part of the steps of the method described in various embodiments of the present invention.

The above are only specific embodiments of the present invention, but the scope of protection of the present invention is not limited to this. Any skilled familiar with the technical field can easily think of various equivalent modifications or substitutions within the technical scope disclosed in the present invention, and these modifications or substitutions should be included in the scope of protection of the present invention. Therefore, the scope of protection of the present invention should be defined by the scope of protection of the appended claims.

## Claims

1. A de-supporting forging printing method, comprising:
obtaining (S110) a stress field concentration area by simulating a stress field for a geometric model of a workpiece to be printed during a forging printing process through a numerical simulation method;
obtaining (S120) stress distribution data by performing different numbers of forging printing simulations on the stress field concentration area with ultrafast laser under a de-supporting condition based on the numerical simulation method;
selecting (S130) target stress distribution data from the stress distribution data according to a preset stress range, and determining a powder bed laser configuration parameter and an ultrafast laser configuration parameter according to the target stress distribution data, wherein the powder bed laser configuration parameter comprises a powder bed laser parameter and a powder bed scanning path, and the ultrafast laser configuration parameter comprises an ultrafast laser parameter and an ultrafast laser scanning path; and
controlling (S140) powder bed laser and ultrafast laser to perform forging printing on the workpiece to be printed according to corresponding laser parameters and scanning paths;
selecting (S130) target stress distribution data from the stress distribution data according to the preset stress range comprises:
determining (S131) whether stress distribution data under each of different numbers of forging printings is within the preset stress range sequentially; and
in response to determining that there are a plurality of sets of stress distribution data are within the preset stress range, determining (S132) that data with a minimum tensile stress in the plurality of sets of stress distribution data is the target stress distribution data;
wherein determining (S130) the powder bed laser configuration parameter and the ultrafast laser configuration parameter according to the target stress distribution data comprises:
determining (S133) a number of forging printings corresponding to the target stress distribution data;
performing (S134) simulated combination on the number of forging printings and the stress field concentration area through a preset path planning method, and determining the powder bed laser configuration parameter and the ultrafast laser configuration parameter; and
generating (S135) a slice file by storing the powder bed laser configuration parameter and the ultrafast laser configuration parameter.

2. The method of claim 1, wherein obtaining (S110) the stress field concentration area by simulating the stress field of the geometric model for the workpiece to be printed during the forging printing process through the numerical simulation method comprises:
determining (S111) a printing parameter by simulating the geometric model through the numerical simulation method; and
determining (S112) the stress field concentration area by performing numerical simulation calculation on the printing parameter.

3. The method of claim 1, wherein controlling (S140) the powder bed laser and the ultrafast laser to perform forging printing on the workpiece to be printed according to corresponding laser parameters and scanning paths comprises:
controlling (S141) the powder bed laser to fuse the workpiece to be printed based on the powder bed laser parameter and the powder bed scanning path; and
controlling (S142), after the powder bed laser is started for a preset time period, the ultrafast laser to perform forging printing on a fused stress field concentration area based on the ultrafast laser parameter, the ultrafast laser scanning path, and the number of forging printings.

4. A de-supporting forging printing system (200), comprising: a powder spreading device (210), a powder bed laser device (220), an image monitoring device (230), an ultrafast laser device (240), and a central controller (250); wherein
the powder spreading device (210) is configured to spread metal powder evenly onto a molding substrate;
the powder bed laser device (220) is configured to emit powder bed laser according to a powder bed laser parameter, and control the powder bed laser to fuse the metal powder according to a powder bed scanning path;
the image monitoring device (230) is configured to obtain a working signal of the powder bed laser device by monitoring the powder bed laser device, and transmit the working signal to the central controller;
the ultrafast laser device (240) is configured to emit ultrafast laser according to an ultrafast laser parameter after receiving an emission signal, and control the ultrafast laser to perform forging printing on a stress field concentration area in a fused metal powder according to an ultrafast laser scanning path and a number of forging printings; and
the central controller (250) is configured to determine a powder bed configuration parameter, an ultrafast laser configuration parameter, and a number of forging printings of the ultrafast laser by receiving an imported slice file, receive the working signal and generate the emission signal, and stop printing work by receiving a stop signal sent by the image monitoring device, wherein the powder bed configuration parameter comprises the powder bed laser parameter and the powder bed scanning path, and the ultrafast laser parameter comprises the ultrafast laser parameter and the ultrafast laser scanning path.

5. The system of claim 4, wherein the image monitoring device (230) is configured to determine whether a scanning path error or a powder spreading defect occurs during a fusing or forging process, and stop the printing work by generating a defect signal in response to determining that the scanning path error or the powder spreading defect occurs.

6. A computer device, comprising: a memory and a processor; wherein the memory has computer instructions stored thereon, and when the processor executes the computer instructions, the method of any one of claims 1 to 3 is performed.

7. A storage medium having a computer program stored thereon, wherein the computer program comprises program instructions, and when the program instructions are executed by the processor, the method of any one of claims 1-3 is performed.
